# EUROPEAN PATENT APPLICATION

(11) **EP 4 598 325 A1**
(43) Date of publication of application: **06.08.2025**
(21) Application number: 23872826.5
(22) Date of filing: 31.08.2023
(51) Int. Cl.: H10K 71/00, H10K 71/16, C23C 14/04

(54) **METAL PLATE AND DEPOSITION MASK COMPRISING SAME**

(30) Priority: 27.09.2022 KR 20220122362
(71) Applicant: LG INNOTEK CO., LTD., Seoul 07796 (KR)
(72) Inventor: LEE, Sang Yu, Seoul 07796 (KR)
(74) Representative: Plasseraud IP
(86) International application number: PCT/KR2023/012997
(87) International publication number: WO 2024/071705

(57) **Abstract**

A metal plate comprising; iron (Fe), nickel (Ni), oxygen (O), and chromium (Cr); and a first region comprising a surface and a second region between the first regions, wherein the first region is formed to a depth of 9 nm from the surface of the metal plate, wherein the first region includes 0 at% to 0.02 at% of chromium.

## Description

### [Technical Field]

An embodiment relates to a metal plate and a deposition mask comprising the same.

### [Background Art]

Display devices are applied to various devices. For example, the display device is applied to a small device such as a smart phone or a tablet PC. Alternatively, the display device is applied to a large-sized device such as a TV, monitor, or public display. Recently, the demand for ultra-high definition (UHD) of 500 pixels per inch (PPI) or more is increasing. Accordingly, display devices having high resolution are being applied to small devices and large devices.

Display devices are classified into liquid crystal display (LCD) and organic light emitting diode (OLED) according to driving methods.

The LCD is a display device driven using liquid crystal. In addition, OLED is a display device driven by using an organic material.

The OLED can express an infinite contrast ratio, has a response speed that is 1000 times faster than LCD, and has an excellent viewing angle. Accordingly, the OELD is attracting attention as a display device that can replace the LCD.

The OLED includes a light emitting layer. The light emitting layer includes an organic material. The organic material is deposited on the substrate using a deposition mask. The deposition mask may include an open mask (OM) or a fine metal mask (FMM). A deposition pattern corresponding to a pattern formed on a deposition mask is formed on the substrate. Accordingly, the deposition pattern may serve as a pixel.

The open mask is a thin plate that forms a deposition pattern only at a specific location when manufacturing an OLED. The open mask is used in a deposition process of forming a light emitting layer thereon after a backplane is completed in a display manufacturing process. That is, the open mask is a mask that does not cover a portion within an operating range of the display in order to deposit the entire surface of the display. Therefore, the open mask is used when depositing a light emitting layer with a light emitting material of one color.

On the other hand, the fine metal mask is used to change the color of the subpixels of the light emitting layer. Accordingly, the fine metal mask includes ultra-fine holes. The process of using the fine metal mask requires a multi-step deposition process. Therefore, the process requires accurate alignment. Accordingly, the process using the fine metal mask is more difficult than the process using the open mask.

When the light emitting layer of the OLED is deposited using an open mask, only a single-color light emitting layer is formed. Therefore, separate color filters are required to implement various colors. On the other hand, when using the fine metal mask, an RGB light emitting layer may be formed. Therefore, a separate color filter is not required. That is, the technique using the fine metal mask has a high degree of difficulty. However, compared to the method using an open mask, light efficiency is good because a filter for blocking light is not required.

The fine metal mask is generally made of an Invar alloy metal plate including iron (Fe) and nickel (Ni). For example, the fine metal mask is made of Invar alloy. It is advantageous to manufacture a mask directly from the metal plate, but it is difficult in reality.

In detail, the metal plate and the deposition mask may be manufactured at different locations. Therefore, when transporting the metal plate to another place, the metal plate may be exposed to air for a long time. In addition, it is difficult to simultaneously use the transferred metal plates in a process of manufacturing a deposition mask. Therefore, the metal plates are sequentially used. Accordingly, a metal plate that is stored for a long time is created.

Accordingly, the metal plate may further include chromium (Cr) to prevent surface corrosion. Chromium (Cr) is an element capable of ensuring corrosion resistance. Corrosion resistance of the metal plate may be improved by chromium (Cr). However, it is difficult to uniformly disperse chromium (Cr) in the composition of the metal plate.

In addition, when the chromium (Cr) is concentrated in a specific region, segregation or formation of the second precipitation phase may be promoted in the process of manufacturing the metal plate. Accordingly, physical properties of the metal plate may be changed. Accordingly, the corrosion resistance and workability of the metal plate are reduced. Therefore, defects may occur when manufacturing the deposition mask. For example, processing characteristics of grooves formed in the metal plate may decrease.

Therefore, there is a need for a metal plate having a new structure and a deposition mask including the metal plate that can solve the above problems.

### [Disclosure]

### [Technical Problem]

An embodiment provides a metal plate having improved corrosion resistance.

An embodiment provides a metal plate having uniform physical properties.

### [Technical Solution]

A metal plate comprising; iron (Fe), nickel (Ni), oxygen (O), and chromium (Cr); and a first region comprising a surface and a second region between the first regions, wherein the first region is formed to a depth of 9 nm from the surface of the metal plate, wherein the first region includes 0 at% to 0.02 at% of chromium.

### [Advantageous Effects]

The atomic concentration of the metal plate according to the embodiment is controlled. In detail, in the metal plate, atomic concentrations of chromium, nickel, iron, and oxygen are controlled in a region of a set depth. In detail, the atomic concentrations of chromium, nickel, iron and oxygen from the surface of the metal plate to a depth of 9 nm are controlled.

The atomic concentration of chromium from the surface to a depth of 9 nm may be 0.02 at% or less. As a result, the atomic composition of the surface of the metal plate becomes uniform. In addition, precipitation of chromium is prevented. Also, the formation of particles formed by chromium is minimized.

Accordingly, defects in through-holes of the deposition mask manufactured by the metal plate are reduced. Accordingly, the reliability of the deposition mask is improved.

In addition, the atomic concentrations of nickel, iron and oxygen are controlled at a depth of 3.6 nm to 9 nm. Accordingly, the corrosion resistance of the metal plate is increased. Thus, corrosion of the metal plate is prevented.

Accordingly, defects in through-holes of the deposition mask manufactured by the metal plate are reduced. Accordingly, the reliability of the deposition mask is improved.

### [Description of Drawings]

FIG 1. is a cross-sectional view of a metal plate according to an embodiment.
FIG 2 is a photograph of the metal plate of an experimental example in which corrosion is formed.
FIG 3 is a view for explaining a defect in a through-hole of a deposition mask according to an experimental example.
FIG. 4 is a view showing a combination of a deposition mask and a frame according to an embodiment.
FIG.5 is a cross-sectional view of an organic material deposition apparatus including the deposition mask according to the embodiment.
FIG. 6 is a view illustrating formation of a deposition pattern on a deposition substrate by through-holes of the deposition mask according to the embodiment.
FIG. 7 is a plan view of the deposition mask according to a first embodiment

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and replaced. In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

The deposition mask described below is a fine metal mask capable of forming an RGB pixel pattern on the deposition substrate by depositing red, green, and blue organic materials on the deposition substrate. In addition, the following description does not apply to the open mask.

In addition, the first direction 1D is defined as the longitudinal direction of the deposition mask. The second direction 2D is defined as the width direction of the deposition mask.

Hereinafter, a metal plate according to an embodiment will be described with reference to the drawings.

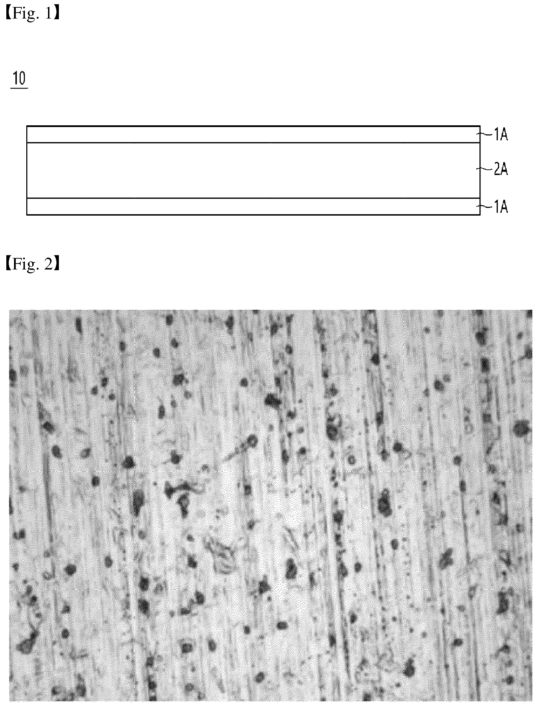

FIG. 1 is a cross-sectional view of a metal plate according to an embodiment.

Referring to FIG. 1, the metal plate 10 includes a nickel (Ni) alloy. For example, the metal plate 10 may include a nickel (Ni)-iron (Fe) alloy. For example, the metal plate 10 may include iron (Fe), nickel (Ni), chromium (Cr), and oxygen (O). For example, the metal plate 10 may include iron (Fe), nickel (Ni), chromium (Cr), oxygen (O), and carbon (C).

The iron is included in 60 wt% to 65 wt%. In addition, the nickel is included in 35 wt% to 40 wt%. Components and weight % of the metal plate 10 are confirmed by sampling a specific region. For example, a specific region (a*b) is selected on the plane of the metal plate 10. Subsequently, specimens (a*b*t) corresponding to the thickness t of the metal plate 10 are sampled. Subsequently, the specimen is dissolved in strong acid to check the weight % of each component. However, the embodiment is not limited thereto.

Specifically, the iron is included in 63.5 wt% to 64.5 wt%. In addition, the nickel is included in 35.5 wt% to 36.5 wt%. In addition, the metal plate 10 may further include at least one element of a small amount of carbon (C), silicon (Si), sulfur (S), phosphorus (P), manganese (Mn), titanium (Ti), cobalt (Co), copper (Cu), silver (Ag), vanadium (V), niobium (Nb), indium (In), and antimony (Sb). The small amount means less than or equal to 1 wt%.

That is, the metal plate 10 includes invar. The invar is an alloy containing iron and nickel. The invar is a low thermal expansion alloy having a thermal expansion coefficient close to zero. That is, the invar has a very small thermal expansion coefficient. Therefore, it is used for precision parts or precision devices such as deposition masks. Therefore, the deposition mask manufactured using the metal plate 10 has improved reliability. Therefore, deformation of the deposition mask may be prevented. In addition, the lifetime of the deposition mask is increased.

The metal plate 10 is manufactured by a cold rolling method. In detail, the metal plate 10 is formed by melting, forging, hot rolling, normalizing, primary cold rolling, primary annealing, secondary cold rolling, and secondary annealing. In addition, the metal plate has a thickness of about 30 µm or less by the above processes or an additional thickness reduction process. In addition, the surface atom concentration of the metal plate 10 may change during the manufacturing process of the metal plate 10. In detail, the metal plate 10 includes a first area 1A including a surface and a second area 2A other than the first area 1A. In addition, the atomic concentration of the first region 1A and the atomic concentration of the second region 2A may be different.

The metal plate 10 may have a rectangular shape. In detail, the shape of the metal plate 10 may be a rectangle having a long axis and a short axis. In addition, the thickness of the metal plate may be about 30 µm or less.

The metal plate 10 is divided into the first region 1A and the second region 2A. The first region 1A includes the surface of the metal plate 10. Accordingly, the first region 1A has a depth within a set range from the upper and lower surfaces of the metal plate 10. Also, the second area 2A has a depth within a set range between the first areas 1A.

The first region 1A is a region in which the atomic concentration of the metal plate may be changed by an annealing process.

The first area 1A has a depth within a set range. In detail, the first region 1A has a depth of 9 nm from the surface of the metal plate 10. Accordingly, the atomic concentration may be changed at a depth of 9 nm from the surface of the metal plate 10 by the annealing process.

The surface of the metal plate 10 is etched. As a result, a plurality of through-holes are formed in the metal plate. In this way, a deposition mask is manufactured.

When the surface of the metal plate is corroded, the through-holes may not be uniform. Alternatively, when particles of impurities are present on the surface of the metal plate, the through-holes may not be uniform. For example, the size or shape of the through-hole may not be uniform. Accordingly, the deposition quality of the deposition mask is reduced.

Therefore, the metal plate according to the embodiment controls the composition of the first region. Accordingly, the through-holes may have a uniform size and shape.

Elements of the first region 1A may have an atomic concentration within a set range.

The type and concentration of the elements of the metal plate 10 may be confirmed by X-ray photoelectron spectroscopy (XPS). The XPS is one of electron spectroscopy methods. The XPS analyzes elements using an X-ray light source. In detail, when the metal plate is irradiated with X-rays, photoelectrons are emitted out of the material. Kinetic energy reflects the magnitude of bonding energy at the position of an atom constituting the material. Thus, the composition and bonding state of the material may be confirmed.

In the embodiment, elements of the metal plate 10 are measured using XPS equipment (manufactured by ULVAL-PHI). The angle of incidence of X-rays is 90 degrees. In addition, the photoelectron injection angle is 40 degrees. In addition, the energy source of the X-rays used is Monochromated Al-Kα (hv=1486.6 eV). In addition, a 100 µm Φ area of the sample metal plate was measured with an X-ray output of 15 kV and 1.6 mA.

The first region 1A includes chromium having an atomic concentration within a set range. In detail, the first region 1A may include 0.02 at% or less of chromium. In more detail, the first region 1A may include 0 at% to 0.02 at%, 0.005 at% to 0.015 at%, or 0.01 at% to 0.013 at% of chromium.

In detail, the metal plate 10 may include 0 at% to 0.02 at%, 0.005 at% to 0.015 at%, or 0.01 at% to 0.013 at% of chromium at a depth of 9 nm from the surface.

Accordingly, the concentration of chromium in the first region 1A may be minimized. Corrosion resistance of the metal plate 10 is improved by the chromium. However, it is difficult for the chromium to be uniformly dispersed in the composition for manufacturing the metal plate 10. Accordingly, when the concentration of chromium in the surface layer increases, the concentration of chromium in the surface layer may vary depending on the depth. Accordingly, segregation and a second precipitated phase may be formed by the chromium in the chromium-rich region. As a result, physical properties of the metal plate 10 may be changed. In addition, the chromium may combine with other elements to form impurity particles on the surface of the metal plate. Accordingly, the surface roughness of the metal plate 10 is not uniform.

Therefore, the metal plate 10 minimizes the chromium content. Therefore, the surface layer has uniform physical properties and surface roughness. Accordingly, when manufacturing the deposition mask 100 by processing the metal plate 10, the processability of the metal plate is improved. In detail, when the through-hole is formed by etching one surface and the other surface of the metal plate 10, the size and shape of the through-hole become uniform.

The first region 1A has a nickel atomic concentration (at%) / oxygen atomic concentration (at%) within a set range. In detail, the first region 1A has a nickel atomic concentration (at%) / oxygen atomic concentration within a predetermined range at a depth within a predetermined range.

In detail, the first region 1A may have a nickel atomic concentration (at%) / oxygen atomic concentration (at%) greater than 6 at a depth of 3.6 nm to 9 nm. In more detail, the first region 1A may have a nickel atomic concentration (at%) / oxygen atomic concentration (at%) of 6 to 30, 8 to 30, or 10 to 30 at a depth of 3.6 nm to 9 nm.

In addition, at a depth of 3.6 nm to 9 nm, as the first region 1A deepens, the nickel atomic concentration (at%) / oxygen atomic concentration (at%) may gradually increase.

When the nickel atomic concentration (at%) / oxygen atomic concentration (at%) is less than 6 at a depth from 3.6 nm to 9 nm, the nickel content of the metal plate is reduced. Accordingly, corrosion occurs on the surface of the metal plate. Accordingly, when the deposition mask is manufactured, the size of the through-hole becomes non-uniform. In addition, when the nickel atomic concentration (at%) / oxygen atomic concentration (at%) exceeds 30, the nickel content becomes very large. Accordingly, the characteristics of invar may change. For example, the thermal expansion coefficient of the metal plate may increase.

In addition, the first region 1A may have an iron atomic concentration (at%) / nickel atomic concentration (at%) within a set range. In detail, the first region 1A may have an iron atomic concentration (at%) / nickel atomic concentration (at%) within a set range at a depth within a set range.

In detail, the first region 1A may have an iron atomic concentration (at%) / nickel atomic concentration (at%) of greater than 1 to less than 1.5 at a depth of 3.6 nm to 9 nm. In more detail, the first region 1A may have an iron atomic concentration (at%) / nickel atom concentration (at%) of 1.1 to 1.49 or 1.15 to 1.47 at a depth of 3.6 nm to 9 nm.

In addition, at a depth of 3.6 nm to 9 nm, as the first region 1A deepens, the iron atomic concentration (at%) / nickel atomic concentration (at%) may gradually increase.

When the iron atomic concentration (at%) / nickel atomic concentration (at%) exceeds 1.5 at a depth from 3.6 nm to 9 nm, the nickel content of the metal plate decreases. Accordingly, corrosion occurs in the surface layer of the metal plate. Accordingly, when the deposition mask is manufactured, the size of the through-hole becomes non-uniform. Further, when the iron atomic concentration (at%) / nickel atomic concentration (at%) is 1 or less, the ratio of iron to nickel changes. Accordingly, the characteristics of invar may change. For example, the thermal expansion coefficient of the metal plate may increase.

Hereinafter, the present invention will be described in more detail through Examples and Comparative Examples.

### Example 1

To measure the element concentration according to the depth of the metal plate, 6 samples of the same size are fabricated by processing random regions of the metal plate. Each of the samples is produced in a width of 1 cm and a length of 1 cm.

Subsequently, the surface atoms of the metal plate are rearranged by annealing the metal plate. This controls the atomic concentration on the surface of the metal plate.

In detail, the annealing process is performed at a temperature of 550° C. to 650° C. for 45 seconds to 75 seconds.

The annealing process is performed in an inert gas atmosphere. The annealing process is performed in the inert gas atmosphere such as helium, nitrogen and argon. The atmosphere is an atmosphere in which 90% or more of the inert gas is present.

Subsequently, the atomic concentration (at%) of an element from the surface of the metal plate to a set depth is measured using sputtering and X-ray elemental analysis. At this time, it is measured under constant temperature and humidity conditions of a temperature of 25 ° C and a humidity of 40% to 50%.

Then, the corrosion properties of Samples 1 to 6 were evaluated.

Evaluation of corrosion properties is carried out at a temperature of 85 ° C. and a humidity of 85%. The evaluation time is from 1 hour to a maximum of 48 hours.

Proceed with three test specimens for each sample. It proceeds without surface treatment before the corrosion property evaluation. At this time, the specimen is checked every 2 hours during the evaluation. It is judged as NG by checking the time when corrosion is confirmed.

Corrosion forms appear in black, gray and reddish colors. The number of corrosion is hundreds to thousands per unit area (100cm²). Figure 2 is a photograph when corrosion is formed on the metal plate.

Then, if corrosion of the surface is confirmed in the time between 4 hours and 12 hours, it is determined as NG. If corrosion of the surface is confirmed in the time between 12 hours and 48 hours, it is determined as OK.

In addition, reliability characteristics of samples 7 to 8 were evaluated.

To evaluate the reliability characteristics, three deposition masks were manufactured using the metal plate. 70 million through-holes are formed in each deposition mask.

Subsequently, in one deposition mask, defects in through-holes according to the atomic concentration of chromium are checked.

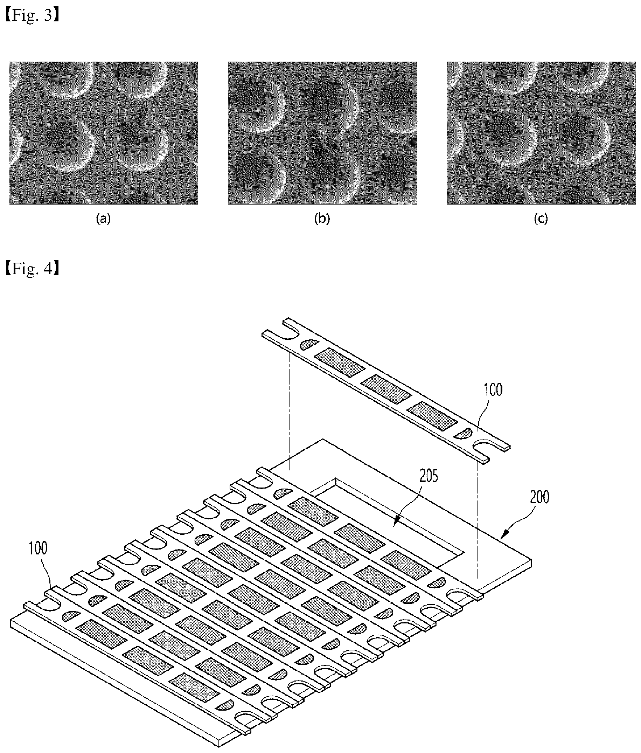

The defect of the through-hole is defined as a through-hole having a diameter larger than that of the other through-holes as shown in FIG. 3(a), through-holes connected to each other as shown in FIG. 3(b), and through-holes having a diameter smaller than that of the other through-holes as shown in FIG. 3(c).

**[Table 1]**

| sputtering time (min) | Carbon( C) | Oxygen( O) | Chromiu m (Cr) | Iron (Fe) | Nickel (Ni) |
|---|---|---|---|---|---|
| 0 | 38.29 | 43.95 | 0.00 | 12.14 | 5.62 |
| 0.3 | 0.00 | 30.75 | 0.01 | 40.09 | 29.15 |
| 0.6 | 0.24 | 6.53 | 0.02 | 50.33 | 42.88 |
| 0.9 | 0.00 | 4.41 | 0.00 | 54.65 | 40.93 |
| 1.2 | 0.00 | 3.03 | 0.00 | 56.57 | 40.40 |
| 1.5 | 0.22 | 1.33 | 0.00 | 58.57 | 39.88 |
| 1.8 | 0.76 | 1.67 | 0.01 | 57.20 | 40.36 |
| 2.1 | 0.00 | 2.20 | 0.00 | 59.76 | 38.04 |
| 2.4 | 0.00 | 2.44 | 0.00 | 58.12 | 39.44 |
| 2.7 | 0.00 | 2.04 | 0.01 | 58.92 | 39.04 |
| 3 | 1.37 | 1.31 | 0.01 | 60.05 | 38.62 |
| 3.3 | 0.00 | 2.09 | 0.01 | 57.41 | 39.12 |
| 3.6 | 0.58 | 0.32 | 0.00 | 60.20 | 39.48 |
| 3.9 | 0.00 | 2.06 | 0.02 | 57.78 | 39.57 |
| 4.2 | 0.00 | 1.58 | 0.00 | 59.06 | 39.36 |
| 4.5 | 0.00 | 1.40 | 0.02 | 56.31 | 42.27 |
| 4.8 | 0.00 | 1.63 | 0.00 | 58.48 | 39.90 |
| 5.1 | 0.00 | 0.43 | 0.03 | 60.82 | 38.72 |

**[Table 2]**

| sputtering time (min) | Carbon( C) | Oxygen( O) | Chromiu m (Cr) | Iron (Fe) | Nickel (Ni) |
|---|---|---|---|---|---|
| 0.6 | 0.24 | 6.53 | 0.02 | 51.33 | 41.88 |
| 0.9 | 0.00 | 4.41 | 0.00 | 53.35 | 42.43 |
| 1.2 | 0.00 | 3.03 | 0.00 | 56.27 | 40.70 |
| 1.5 | 0.20 | 1.35 | 0.00 | 57.57 | 40.88 |
| 1.8 | 0.81 | 1.62 | 0.00 | 55.20 | 42.36 |
| 2.1 | 0.00 | 2.20 | 0.01 | 59.06 | 38.74 |
| 2.4 | 0.00 | 2.44 | 0.00 | 60.12 | 37.44 |
| 2.7 | 0.00 | 2.04 | 0.01 | 58.92 | 39.04 |
| 3 | 1.31 | 1.37 | 0.01 | 60.15 | 38.52 |
| 3.3 | 0.00 | 2.09 | 0.00 | 58.41 | 38.12 |
| 3.6 | 0.60 | 0.30 | 0.01 | 60.10 | 39.58 |
| 3.9 | 0.00 | 2.06 | 0.02 | 58.78 | 38.57 |
| 4.2 | 0.00 | 1.58 | 0.00 | 60.06 | 38.36 |
| 4.5 | 0.00 | 1.40 | 0.00 | 58.31 | 40.27 |
| 4.8 | 0.00 | 1.63 | 0.02 | 59.48 | 40.90 |
| 5.1 | 0.00 | 0.43 | 0.03 | 60.82 | 38.72 |

**[Table 3]**

| sputtering time (min) | Carbon( C) | Oxygen( O) | Chromiu m (Cr) | Iron (Fe) | Nickel (Ni) |
|---|---|---|---|---|---|
| 0.6 | 0.20 | 6.57 | 0.01 | 52.33 | 40.88 |
| 0.9 | 0.00 | 4.41 | 0.00 | 52.35 | 43.43 |
| 1.2 | 0.00 | 3.03 | 0.00 | 56.77 | 40.20 |
| 1.5 | 0.18 | 1.37 | 0.00 | 57.37 | 41.08 |
| 1.8 | 0.85 | 1.58 | 0.00 | 56.20 | 41.36 |
| 2.1 | 0.00 | 2.20 | 0.01 | 59.36 | 38.44 |
| 2.4 | 0.00 | 2.44 | 0.00 | 60.32 | 37.24 |
| 2.7 | 0.00 | 2.04 | 0.02 | 59.92 | 38.04 |
| 3 | 1.29 | 1.39 | 0.01 | 59.15 | 39.52 |
| 3.3 | 0.00 | 2.09 | 0.00 | 58.11 | 38.42 |
| 3.6 | 0.60 | 0.30 | 0.01 | 59.10 | 40.58 |
| 3.9 | 0.00 | 2.06 | 0.02 | 58.58 | 38.77 |
| 4.2 | 0.00 | 1.58 | 0.00 | 59.86 | 38.56 |
| 4.5 | 0.00 | 1.40 | 0.00 | 57.31 | 41.27 |
| 4.8 | 0.00 | 1.63 | 0.02 | 60.48 | 39.90 |
| 5.1 | 0.00 | 0.43 | 0.02 | 60.82 | 38.72 |

**[Table 4]**

| sputtering time (min) | Carbon( C) | Oxygen( O) | Chromiu m (Cr) | Iron (Fe) | Nickel (Ni) |
|---|---|---|---|---|---|
| 0.6 | 0.24 | 18.39 | 0.02 | 47.38 | 33.44 |
| 0.9 | 0.00 | 9.58 | 0.00 | 53.11 | 34.17 |
| 1.2 | 0.00 | 7.78 | 0.00 | 59.33 | 32.72 |
| 1.5 | 0.20 | 4.88 | 0.00 | 58.28 | 36.74 |
| 1.8 | 0.81 | 2.21 | 0.00 | 57.52 | 38.61 |
| 2.1 | 0.00 | 1.29 | 0.01 | 59.50 | 38.65 |
| 2.4 | 0.00 | 2.25 | 0.00 | 59.94 | 37.51 |
| 2.7 | 0.00 | 4.08 | 0.01 | 56.37 | 39.34 |
| 3 | 1.31 | 2.86 | 0.01 | 58.89 | 34.07 |
| 3.3 | 0.00 | 2.42 | 0.00 | 57.00 | 39.39 |
| 3.6 | 0.60 | 3.00 | 0.01 | 57.21 | 39.79 |
| 3.9 | 0.00 | 0.00 | 0.02 | 61.21 | 38.62 |
| 4.2 | 0.00 | 2.56 | 0.00 | 59.63 | 37.82 |
| 4.5 | 0.00 | 1.01 | 0.00 | 57.55 | 41.15 |
| 4.8 | 0.00 | 0.84 | 0.02 | 59.88 | 39.28 |
| 5.1 | 0.00 | 0.00 | 0.03 | 59.34 | 40.66 |

**[Table 5]**

| sputtering time (min) | Carbon( C) | Oxygen( O) | Chromiu m (Cr) | Iron (Fe) | Nickel (Ni) |
|---|---|---|---|---|---|
| 0.6 | 0.54 | 18.09 | 0.02 | 46.38 | 34.44 |
| 0.9 | 0.00 | 9.58 | 0.00 | 53.51 | 33.67 |
| 1.2 | 0.00 | 7.78 | 0.00 | 60.33 | 31.72 |
| 1.5 | 0.30 | 4.78 | 0.00 | 59.28 | 35.74 |
| 1.8 | 0.61 | 2.41 | 0.00 | 58.52 | 37.61 |
| 2.1 | 0.00 | 1.29 | 0.01 | 60.50 | 37.65 |
| 2.4 | 0.00 | 2.25 | 0.00 | 60.94 | 36.51 |
| 2.7 | 0.00 | 4.08 | 0.01 | 56.87 | 38.84 |
| 3 | 1.11 | 3.06 | 0.01 | 60.89 | 32.07 |
| 3.3 | 0.00 | 2.42 | 0.00 | 57.30 | 39.09 |
| 3.6 | 0.70 | 2.90 | 0.01 | 57.01 | 39.59 |
| 3.9 | 0.00 | 0.00 | 0.02 | 61.01 | 38.42 |
| 4.2 | 0.00 | 2.56 | 0.00 | 59.03 | 37.22 |
| 4.5 | 0.00 | 1.01 | 0.00 | 57.25 | 41.45 |
| 4.8 | 0.00 | 0.84 | 0.02 | 60.88 | 38.28 |
| 5.1 | 0.00 | 0.00 | 0.03 | 58.34 | 41.66 |

**[Table 6]**

| sputtering time (min) | Carbon( C) | Oxygen( O) | Chromiu m (Cr) | Iron (Fe) | Nickel (Ni) |
|---|---|---|---|---|---|
| 0.6 | 0.24 | 18.39 | 0.02 | 48.38 | 31.44 |
| 0.9 | 0.00 | 9.58 | 0.00 | 55.11 | 32.17 |
| 1.2 | 0.00 | 7.78 | 0.00 | 61.33 | 30.72 |
| 1.5 | 0.10 | 4.98 | 0.00 | 60.28 | 34.74 |
| 1.8 | 0.91 | 2.11 | 0.00 | 60.52 | 35.61 |
| 2.1 | 0.00 | 1.29 | 0.01 | 60.50 | 39.65 |
| 2.4 | 0.00 | 2.25 | 0.00 | 61.94 | 35.51 |
| 2.7 | 0.00 | 4.08 | 0.01 | 59.37 | 36.34 |
| 3 | 1.51 | 2.66 | 0.01 | 60.89 | 32.07 |
| 3.3 | 0.00 | 2.42 | 0.00 | 58.00 | 38.39 |
| 3.6 | 0.90 | 2.70 | 0.01 | 56.21 | 40.79 |
| 3.9 | 0.00 | 0.00 | 0.02 | 60.21 | 39.62 |
| 4.2 | 0.00 | 2.56 | 0.00 | 57.63 | 39.82 |
| 4.5 | 0.00 | 1.01 | 0.00 | 58.55 | 40.15 |
| 4.8 | 0.00 | 0.84 | 0.02 | 58.88 | 40.28 |
| 5.1 | 0.00 | 0.00 | 0.03 | 59.34 | 40.66 |

**[Table 7]**

| | Corrosion evaluation |
|---|---|
| Sample 1 | OK |
| Sample 2 | OK |
| Sample 3 | OK |
| Sample 4 | NG |
| Sample 5 | NG |
| Sample 6 | NG |

**[Table 8]**

| sputtering time (min) | Carbon( C) | Oxygen( O) | Chromiu m (Cr) | Iron (Fe) | Nickel (Ni) |
|---|---|---|---|---|---|
| 0 | 38.29 | 43.95 | 0.00 | 12.14 | 5.62 |
| 0.3 | 0.00 | 30.75 | 0.01 | 40.09 | 29.15 |
| 0.6 | 0.24 | 6.53 | 0.02 | 50.33 | 42.88 |
| 0.9 | 0.00 | 4.41 | 0.00 | 54.65 | 40.93 |
| 1.2 | 0.00 | 3.03 | 0.00 | 56.57 | 40.40 |
| 1.5 | 0.22 | 1.33 | 0.00 | 58.57 | 39.88 |
| 1.8 | 0.76 | 1.67 | 0.01 | 57.20 | 40.36 |
| 2.1 | 0.00 | 2.20 | 0.00 | 59.76 | 38.04 |
| 2.4 | 0.00 | 2.44 | 0.00 | 58.12 | 39.44 |
| 2.7 | 0.00 | 2.04 | 0.01 | 58.92 | 39.04 |
| 3 | 1.37 | 1.31 | 0.01 | 60.05 | 38.62 |
| 3.3 | 0.00 | 2.09 | 0.01 | 57.41 | 39.12 |
| 3.6 | 0.58 | 0.32 | 0.00 | 60.20 | 39.48 |
| 3.9 | 0.00 | 2.06 | 0.02 | 57.78 | 39.57 |
| 4.2 | 0.00 | 1.58 | 0.00 | 59.06 | 39.36 |
| 4.5 | 0.00 | 1.40 | 0.02 | 56.31 | 42.27 |
| 4.8 | 0.00 | 1.63 | 0.00 | 58.48 | 39.90 |
| 5.1 | 0.00 | 0.43 | 0.03 | 60.82 | 38.72 |

**[Table 9]**

| sputtering time (min) | Carbon( C) | Oxygen( O) | Chromiu m (Cr) | Iron (Fe) | Nickel (Ni) |
|---|---|---|---|---|---|
| 0 | 503.77 | 38.76 | 1.18 | 6.77 | 2.52 |
| 0.3 | 0.00 | 38.40 | 0.64 | 40.19 | 20.17 |
| 0.6 | .07. | 18.39 | 0.08 | 47.39 | 33.44 |
| 0.9 | 3.15 | 9.58 | 0.00 | 53.11 | 34.17 |
| 1.2 | 0.00 | 7.78 | 0.17 | 59.33 | 32.72 |
| 1.5 | 0.00 | 4.88 | 0.11 | 58.28 | 36.74 |
| 1.8 | 1.27 | 2.21 | 0.38 | 57.52 | 38.61 |
| 2.1 | 0.00 | 1.29 | 0.56 | 59.50 | 38.65 |
| 2.4 | 0.00 | 2.25 | 0.30 | 59.94 | 37.51 |
| 2.7 | 0.00 | 4.08 | 0.20 | 56.37 | 39.34 |
| 3 | 4.19 | 2.86 | 0.00 | 58.89 | 343.07 |
| 3.3 | 1.19 | 2.42 | 0.00 | 57.00 | 39.39 |
| 3.6 | 0.00 | 3.00 | 0.00 | 57.21 | 39.79 |
| 3.9 | 0.00 | 0.00 | 0.18 | 61.21 | 38.62 |
| 4.2 | 0.00 | 2.56 | 0.00 | 59.63 | 37.82 |
| 4.5 | 0.00 | 1.01 | 0.29 | 57.55 | 41.15 |
| 4.8 | 0.00 | 0.84 | 0.00 | 59.88 | 39.28 |
| 5.1 | 0.00 | 0.00 | 0.00 | 59.34 | 40.66 |

**[Table 10]**

| | Defect rate of through-hole (%) |
|---|---|
| | (Defective through-hole / Full through hole × 100) |
| Sample 7 | 10% or less |
| Sample 8 | 10%~30% |

Table 1 is the elemental atomic concentration of the metal plate of Sample 1. Table 2 is the elemental atomic concentration of the metal plate of Sample 2. Table 3 is the elemental atomic concentration of the metal plate of Sample 3. Table 4 is the elemental atomic concentration of the metal plate of Sample 4. Table 5 is the elemental atomic concentration of the metal plate of Sample 5. Table 6 is the elemental atomic concentration of the metal plate of Sample 6.

Table 7 shows the results of corrosion evaluation for samples 1 to 6.

In Tables 1 to 6, the 0.6 minute region is a 3 nm to 4 nm depth point of the metal plate 10. In detail, the 0.6 minute region is a result of measurement at a depth of about 3.6 nm. Also, the 1.5 minute region is a depth point of 8 nm to 10 nm of the metal plate 10. In detail, the 1.5 minute region is the result of measurement at a depth of about 9 nm. That is, when sputtering is performed on the metal plate 10 for 0.1 minute, the composition of the metal plate 10 at a depth of about 0.6 nm may be measured. While sputtering is in progress, XPS may be used to confirm the composition and atomic concentration at a specific depth. Accordingly, the concentration of a specific atom and maximum concentration may be identified in a specific depth range. In addition, the trend of increasing and decreasing the specific atom concentration may be confirmed.

Samples 1 to 3 have improved corrosion properties compared to samples 4 to 6. The metal plates of samples 1 to 3 control the atomic concentration ratio of nickel and oxygen. Alternatively, the metal plates of samples 1 to 3 control the atomic concentration ratio of nickel and iron. As a result, the content of nickel having high corrosion resistance is greater than that of the metal plates of Samples 4 to 6. Accordingly, the metal plates of Samples 1 to 3 have improved corrosion resistance. Accordingly, the corrosion rate of the metal plate is reduced. Therefore, even if the metal plate is stored for a long time, corrosion of the metal plate may be minimized. Accordingly, the uniformity of the size and shape of the through-hole of the deposition mask is improved.

The deposition mask manufactured by sample 7 has fewer through-hole defects than the deposition mask manufactured by sample 8. The metal plate of Sample 7 has a decreasing atomic concentration of chromium at a set depth. Accordingly, the composition may be made uniform on the surface of the metal plate. In addition, the formation of particles due to the precipitated phase may be prevented. Accordingly, defects in through-holes of the deposition mask are reduced.

Referring to the drawings, a deposition mask manufactured by the metal plate will be described.

The deposition mask described below is a fine metal mask capable of forming an RGB pixel pattern on the deposition substrate by depositing red, green, and blue organic materials on the deposition substrate. In addition, the following description does not apply to the open mask.

FIGS. 4 to 7 are views for explaining a process of depositing an organic material on a deposition substrate 300 using a deposition mask 100 according to an embodiment.

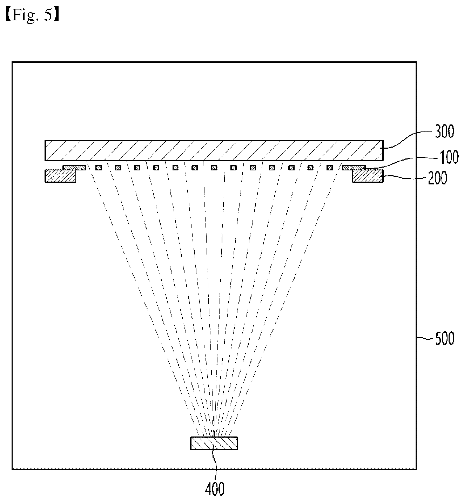

Referring to FIGS. 4 and 5, the organic material deposition apparatus includes a deposition mask 100, a mask frame 200, a deposition substrate 300, an organic material deposition container 400 and a vacuum chamber 500.

The deposition mask 100 includes a plurality of through-holes TH formed in an effective portion. The through-holes are formed to correspond to patterns to be formed on the deposition substrate. The deposition mask 100 includes an effective portion including a deposition region and a non-effective portion other than the effective portion.

The mask frame 200 includes an opening 205. The plurality of through-holes are disposed on a region corresponding to the opening 205. Accordingly, the organic material supplied to the organic material deposition container 400 is deposited on the deposition substrate 300. The deposition mask 100 is disposed and fixed on the mask frame 200. For example, the deposition mask 100 is tensioned with a set tensile force. In addition, the deposition mask 100 is welded and fixed on the mask frame 200.

For example, the non-effective portion of the deposition mask 100 is welded. Accordingly, the deposition mask 100 is fixed on the mask frame 200. Then, the portion protruding out of the mask frame 200 is cut and removed.

The mask frame 200 includes metal having high rigidity. Thus, deformation of the mask frame during the welding process is reduced.

The deposition substrate 300 is a substrate used when manufacturing a display device. For example, an OLED pixel pattern is formed on the deposition substrate 300. Red, green, and blue organic patterns are formed on the deposition substrate 300 to form pixels that are three primary colors of light. That is, an RGB pattern is formed on the deposition substrate 300.

The organic material deposition container 400 is a crucible. The organic material is disposed inside the crucible. The organic material deposition container 400 moves inside the vacuum chamber 500. That is, the organic material deposition container 400 moves in one direction inside the vacuum chamber 500. For example, the organic material deposition container 400 moves in the width direction of the deposition mask 100 inside the vacuum chamber 500.

A heat source and/or current is supplied to the organic material deposition container 400. As a result, the organic material is deposited on the deposition substrate 300.

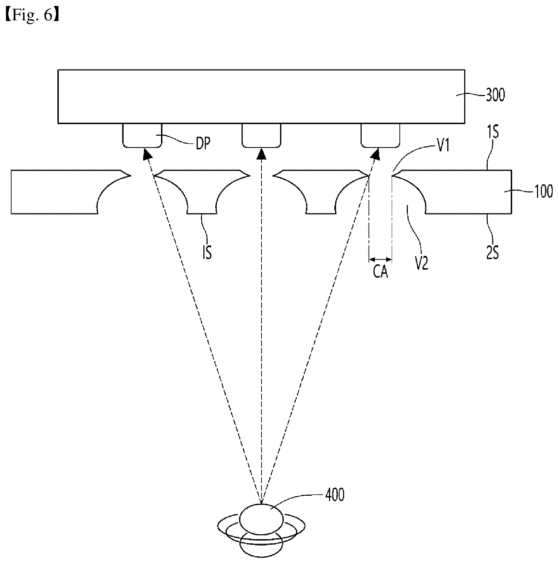

Referring to FIG. 6, the deposition mask 100 includes a metal plate 10. The metal plate includes a first surface 1S and a second surface 2S. The first surface 1S and the second surface 2S are opposite to each other.

The first surface 1S includes a small surface hole V1. The second surface 2S includes a large surface hole V2. For example, a plurality of small surface holes V1 and a plurality of large surface holes V2 are formed on the first surface 1S and the second surface 2S, respectively.

In addition, the deposition mask 100 includes a through-hole TH. The through-hole TH is formed by a connection portion CA connecting the boundary between the small surface hole V1 and the large surface hole V2.

The width of the large surface hole V2 is greater than that of the small surface hole V1. The width of the small surface hole V1 is measured on the first surface 1S of the deposition mask 100. The width of the large surface hole V2 is measured on the second surface 2S of the deposition mask 100.

Also, a width of the connection portion CA has a set size. In detail, the width of the connection portion CA may be 15 µm to 33 µm. In more detail, the width of the connection portion CA may be 19 µm to 33 µm. In more detail, the width of the connection portion CA may be 20 µm to 27 µm. When the width of the connection portion CA exceeds 33 µm, it is difficult to implement a resolution of 500 PPI or higher. In addition, when the width of the connection portion CA is less than 15 µm, defects may occur during the deposition process.

The small surface hole V1 faces the deposition substrate 300. The small surface hole V1 is disposed close to the deposition substrate 300. Accordingly, the small surface hole V1 has a shape corresponding to a deposition pattern DP.

The large surface hole V2 faces the organic material deposition container 400. Accordingly, the organic material supplied from the organic material deposition container 400 may be accommodated in a wide width by the large surface hole V2. In addition, a fine pattern may be rapidly formed on the deposition substrate 300 by the small surface hole V1.

Accordingly, the organic material accommodated by the large surface hole V2 is deposited on the deposition substrate 300 by the small surface hole V1. Accordingly, any one of red, green, and blue pixel patterns is formed on the deposition substrate 300. Then, the above process is repeated. Accordingly, red, green, and blue pixel patterns are all formed on the deposition substrate 300.

Therefore, when the shape or size of the through-hole is not uniform, the shape or size of the deposition pattern is also not uniform. Accordingly, since the shape or size of the deposition pattern deposited on the deposition substrate 300 becomes non-uniform, the deposition quality is reduced.

Therefore, the atomic concentration of the surface of the metal plate forming the deposition mask is controlled. Accordingly, the size or shape of the through-hole is made uniform. Accordingly, the deposition mask may have improved deposition quality.

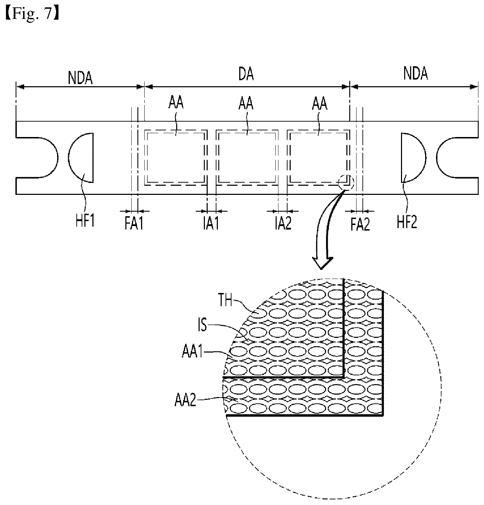

FIG. 7 is a plan view of a deposition mask 100 according to the embodiment.

Referring to FIG. 7, the deposition mask 100 includes a deposition region DA and a non-deposition region NDA.

The deposition region DA is a region for forming the deposition pattern. The deposition region DA includes a pattern region and a non-pattern region. The pattern region is a region including the small surface hole V1, the large surface hole V2, the through-hole TH, and the island portion IS. The non-pattern region is a region that does not include the small surface hole V1, the large surface hole V2, the through-hole TH, and the island portion IS. The island portion IS is a region where the metal plate is not etched.

The deposition region DA includes a plurality of effective region AA. A plurality of deposition patterns are formed in the effective region AA. The effective region is a region where the small surface hole V1, the large surface hole V2, the through-hole TH, and the island portion IS are formed. That is, the organic material of the deposition mask 100 moves by the effective region AA.

The effective region AA may include a first effective region AA1 and a second effective region AA2. The second effective region AA2 surrounds the first effective region AA1. Also, the area of the first effective region AA1 is larger than that of the second effective region AA.

The deposition region DA includes a plurality of separation regions IA1 and IA2. Separation regions IA1 and IA2 are disposed between adjacent effective regions. The separation regions IA1 and IA2 are spaced regions between the plurality of effective regions. Adjacent effective regions may be distinguished from each other by the separation regions IA1 and IA2.

The non-deposition region NDA is a region not involved in deposition. The non-deposition region NDA includes frame fixing regions FA1 and FA2. The frame fixing regions FA1 and FA2 are regions for fixing the deposition mask 100 to the mask frame 200. Also, the non-deposition region NDA may include half-etched portions HF1 and HF2 and an open portion.

The half etching portions HF1 and HF2 may disperse stress generated when the deposition mask 100 is tensioned.

In addition, the open portion may disperse stress generated when the deposition mask 100 is tensioned. Accordingly, deformation of the deposition mask may be reduced.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A metal plate comprising;
iron (Fe), nickel (Ni), oxygen (O), and chromium (Cr); and
a first region comprising a surface and a second region between the first regions,
wherein the first region is formed to a depth of 9 nm from the surface of the metal plate,
wherein the first region includes 0 at% to 0.02 at% of chromium.

2. The metal plate of claim 1, wherein the first region has a nickel atomic concentration (at%) / oxygen atomic concentration (at%) of 6 to 30 at a depth of 3.6 nm to 9 nm.

3. The metal plate of claim 2, wherein at a depth of 3.6 nm to 9 nm, the nickel atomic concentration (at%) / oxygen atomic concentration (at%) increases as the depth of the first region increases.

4. The metal plate of claim 1, The metal plate of claim 1, wherein the first region has an iron atomic concentration (at%) / nickel atomic concentration (at%) of 1 to 1.5 at a depth of 3.6 nm to 9 nm.

5. The metal plate of claim 4, wherein at a depth of 3.6 nm to 9 nm, the iron atomic concentration (at%) / nickel atomic concentration (at%) increases as the depth of the first region increases.

6. A deposition mask comprising;
a metal plate including a deposition region and a non-deposition region,
wherein the deposition region includes a plurality of effective regions and non-effective regions other than the effective regions,
wherein the effective region includes a plurality of through-holes,
wherein the through hole include a small surface hole formed on the first surface of the metal plate; a large surface hole formed on a second surface opposite to the first surface; and a connecting portion connecting the small surface hole and the large surface hole
wherein the metal plate includes iron (Fe), nickel (Ni), oxygen (O), and chromium (Cr),
wherein the metal plate includes a first region comprising a surface and a second region between the first regions,
wherein the first region is formed to a depth of 9 nm from the surface of the metal plate,
wherein the first region includes 0 at% to 0.02 at% of chromium.

7. The deposition mask of claim 6, wherein the first region has a nickel atomic concentration (at%) / oxygen atomic concentration (at%) of 6 to 30 at a depth of 3.6 nm to 9 nm.

8. The deposition mask of claim 7, wherein at a depth of 3.6 nm to 9 nm, the nickel atomic concentration (at%) / oxygen atomic concentration (at%) increases as the depth of the first region increases.

9. The deposition mask of claim 6, The metal plate of claim 1, wherein the first region has an iron atomic concentration (at%) / nickel atomic concentration (at%) of 1 to 1.5 at a depth of 3.6 nm to 9 nm.

10. The deposition mask of claim 9, wherein at a depth of 3.6 nm to 9 nm, the iron atomic concentration (at%) / nickel atomic concentration (at%) increases as the depth of the first region increases.
